# EUROPEAN PATENT APPLICATION

(11) **EP 0 844 656 A1**
(43) Date of publication of application: **27.05.1998**
(21) Application number: 97924372.2
(22) Date of filing: 09.06.1997
(51) Int. Cl.: H01L 21/60

(54) **ELECTRONIC COMPONENT STRUCTURE**

(30) Priority: 10.06.1996 JP 146921/96
(71) Applicant: Matsushita Electric Industrial Co., Ltd., Kadoma-shi, Osaka 571-8501 (JP)
(72) Inventor: TSUKAHARA, Norihito, Soraku-gun,Kyoto 619-0224 (JP)
(74) Representative: Grünecker, Kinkeldey, Stockmair & Schwanhäusser Anwaltssozietät
(86) International application number: JP9701990
(87) International publication number: WO9748131

(57) **Abstract**

When a semiconductor element (1) is bonded to an inner lead (6) of a tape carrier (5), a problem of an operation failure of the semiconductor element (1) that would be caused from result of an excessive amount of an alloy layer (9) flowing toward and coming into contact with an edge portion of the semiconductor element (1) is solved. In an electronic component device in which a metal ball formed by melting a tip end of a metal wire (12) is bonded onto an electrode (2) of the semiconductor element (1) so as to form a bump (11), a plated layer is formed on the surface of the inner lead (6) of the tape carrier (5), and under the condition that the inner lead (6) is positioned in alignment with the bump (11), the plated layer is melted in order that the semiconductor element (1) is bonded to the inner lead (6) through an alloy layer (9), a plurality of bumps (11) are formed on the electrode (2) so as to increase a force to hold the alloy layer (9) and to prevent the alloy layer (9) from flowing therefrom.

## Description

### TECHNICAL FIELD

The present invention relates to an electronic component device in which electrodes of semiconductor elements and inner leads of tape carriers are connected to each other by using an alloy having a low melting point such as solder, and more particularly to an electronic component device in which metal balls formed at ends of metal wires are bonded to the electrodes of the semiconductor elements to form bumps, and are connected to the inner leads of the tape carriers.

### BACKGROUND ART

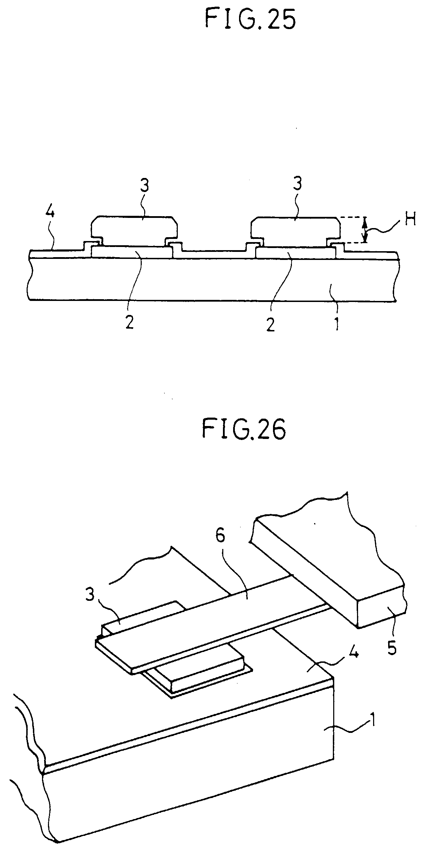

Up to now, there has been exemplified an electronic component device shown, for example, in Figs. 25 to 29, as an electronic component device in which the electrodes of the semiconductor elements and the inner leads of the tape carriers are connected to each other. Namely, as shown in Fig. 25, bumps 3 made of solder, Sn or the like are formed on electrodes 2 of a semiconductor element 1 by an electroplating process as shown in Fig. 25. Reference numeral 4 denotes a passivation film for protecting an active surface of the semiconductor element 1.

Then, as shown in Fig. 26, each inner lead 6 of the tape carrier 5 is positioned above the bump 3 to face thereto, formed on the each electrode 2. Thereafter, as shown in Fig. 27, end portions of the respective inner leads 6 are pressed together by a bonding tool 7 which has been heated. As a result, as shown in Fig. 28, plated layers 8 made of solder, Sn or the like, formed on the surface of the respective inner leads 6, are melted so as to form an electronic component device in which the bumps 3 and the inner leads 6 have been connected to each other through alloy layers 9.

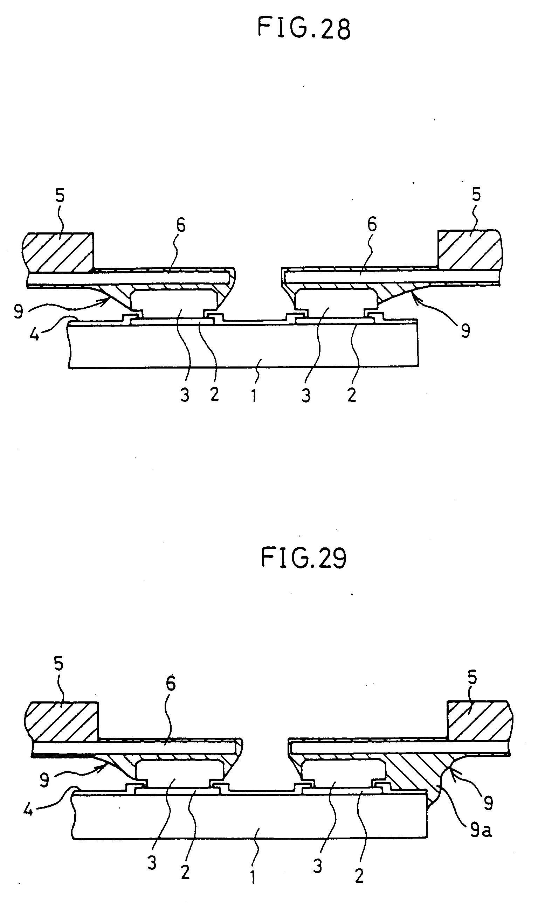

However, since a maximum height H of the bump 3 that may be formed by the electroplating process is low at about 20 µm as shown in Fig. 25, when the above-mentioned plated layers 8 are melted and the bumps 3 and the inner leads 6 are connected to each other through the alloy layers 9 as shown in Fig. 29, gaps between the inner leads 6 and the semiconductor element 1 are small in comparison with the amount of the molten alloy layers 9. An excessive alloy layer 9a is in contact with an edge portion of the semiconductor element 1. As a result, there has been suffered a problem that an operational error of the semiconductor element 1 occurs.

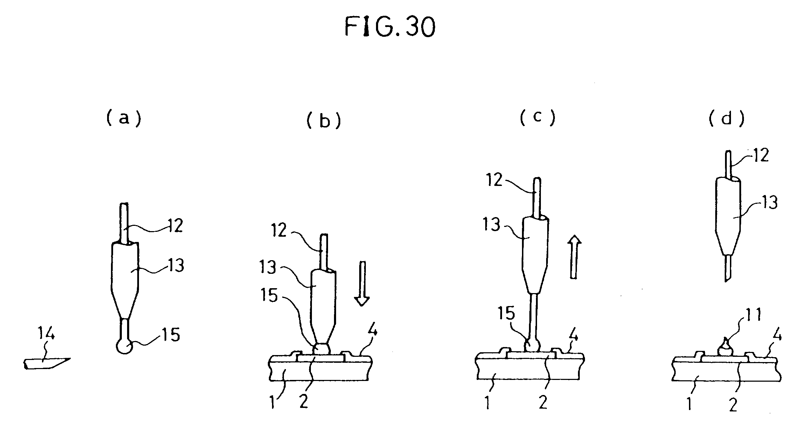

Also, there is exemplified a conventional case in which in order to form a bump which is higher than that of the bump 3 formed by the above-described electroplating process, the bump 11 is formed by a wire bonding process as shown in Figs. 30 to 34. Namely, as shown in Fig. 30 (part (a)), a metal wire 12 made of gold, copper, aluminum, solder or the like is caused to pass through a capillary 13 made of ceramic or ruby, and a discharge is effected between the end of the metal wire 12 which has been caused to pass and an electrode 14 which is called a torch, thereby forming a metal ball 15.

Subsequently, as shown in part (b), the above-described metal ball 15 is pressed against the electrode 2 of the semiconductor element 1 that has been preheated, and a supersonic vibration is applied thereto. The above-described metal ball 15 is bonded to the electrode 2 of the semiconductor element 1 by the effect of a temperature, a pressure and a supersonic vibration. Thereafter, as shown in part (c), the capillary 13 is raised vertically, and as shown in part (d), the metal wire 12 is drawn and cut to form the bump 11 by the metal ball.

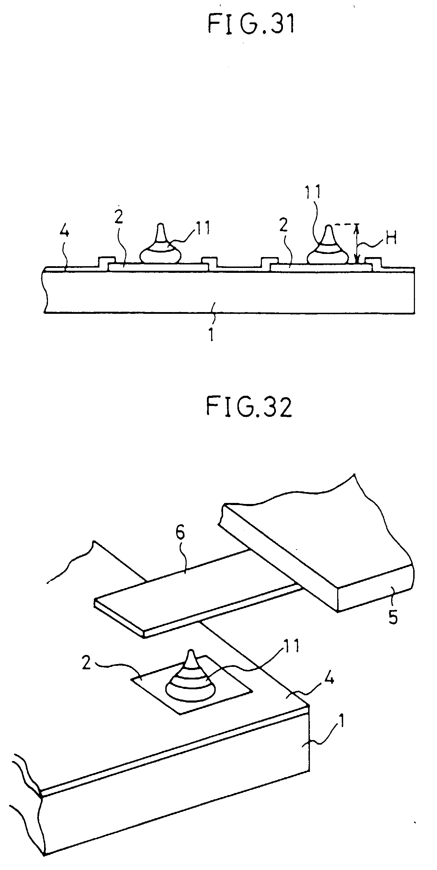

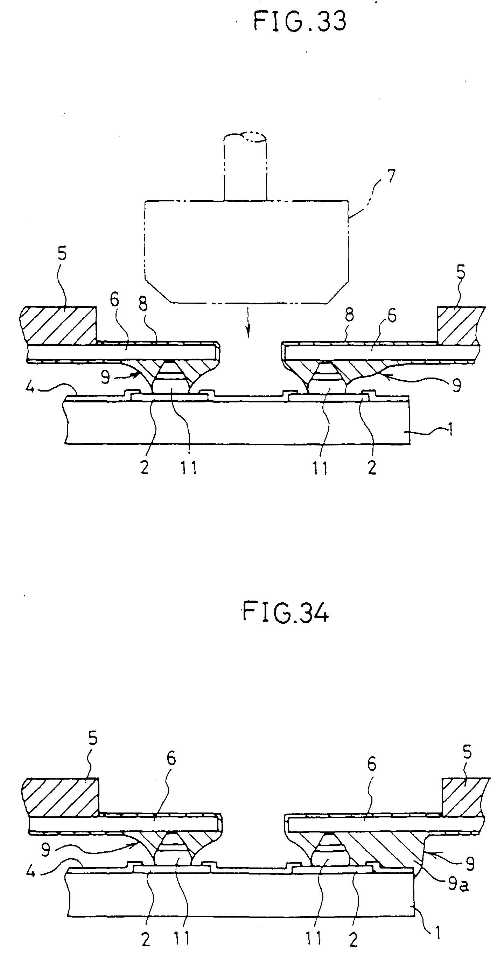

Thus, after, as shown in Fig. 31, the bumps 11 are formed one by one on the respective electrodes 2 of the semiconductor element 1, the inner lead 6 of the tape carrier 5 is positioned above the bump 11 to face thereto, as shown in Fig. 32. The end portions of the respective inner leads 6 are pressed together, as shown in Fig. 33, by the bonding tool 7 which has been heated. As a result, the plated layers 8 made of solder, Sn or the like formed on the surface of the respective inner leads 6 are melted to form the electronic component device in which the bumps 11 made of the metal ball and the inner leads 6 have been connected to each other through the alloy layers 9.

According to this process, as shown in Fig. 31, the maximum height H of the bump 11 which may be formed by the wire bonding process is about 50 µm, which shows that it is possible to heighten the bump in comparison with the bump 3 which has been produced by the electroplating process as shown in Fig. 25.

However, as shown in Fig. 34, in the bumps 11 formed through the wire bonding process, the contact area between the bumps 11 and the alloy layers 9 is small and the force for holding the alloy layers 9 which have been melted is small so that the excessive alloy layer 9a is caused to flow toward and to come into contact with the edge portion of the semiconductor element 1. Therefore, it has been impossible to solve the problem that the operational malfunction of the semiconductor 1 would occur.

In view of the foregoing defects, an object of the present invention is to provide an electronic component device in which an electrode of a semiconductor element and an inner lead of a tape carrier may be bonded to each other with high reliability.

### DISCLOSURE OF THE INVENTION

In an electronic component device according to the present invention, a plurality of bumps made of metal balls are formed on an electrode of a semiconductor element. According to the present invention, it is possible to bond the electrode of the semiconductor element and an inner lead of a tape carrier to each other with high reliability.

According to the invention recited in claim 1 of the present invention, an electronic component device in which, when a semiconductor element is bonded to an inner lead of a tape carrier, a metal ball formed by melting a tip end of a metal wire is bonded onto an electrode of said semiconductor element so as to form a bump on the electrode of said semiconductor element, a plated layer is formed on the surface of said inner lead, and under the condition that said inner lead is positioned in alignment with the bump of the semiconductor element, said plated layer is melted so as to bond the semiconductor element to said inner lead through an alloy layer, wherein a plurality of bumps made of said metal balls are formed on said electrode of the semiconductor element. According to this, after the inner lead has been positioned to face the electrode of the semiconductor element, the tip end of the inner lead is pressed by the heated bonding tool. The plated layer formed on the surface of the inner lead is melted. The bumps and the inner lead are bonded to each other through the alloy layer. In this case, the contact area between the bump and the alloy layer is increased in comparison with the case where the single bump made of metal ball is formed on each electrode of the semiconductor element. As a result, it is possible to increase the force to hold the molten alloy layer. Also, since the plurality of bumps serve as a resistance to prevent the molten alloy layer from flowing, it is possible to prevent the alloy layer from flowing to the edge portion of the semiconductor element to contact thereto. It is therefore possible to bond together the electrode of the semiconductor element and the inner lead of the tape carrier with high reliability.

According to the invention recited in claim 2 of the present invention, an electronic component device in which, when a semiconductor element is bonded to an inner lead of a tape carrier, a metal ball formed by melting a tip end of a metal wire is bonded on an electrode of said semiconductor element so as to form a bump on the electrode of said semiconductor element, a plated layer is formed on the surface of said inner lead, and under the condition that said inner lead is positioned in alignment with the bump of the semiconductor element, said plated layer is melted so as to bond the semiconductor element to said inner lead through an alloy layer, wherein a metal ball formed at a tip end of the metal wire is further bonded to said bump on the bump made of said metal ball and formed on the electrode of said semiconductor element, and said metal wire is drawn and cut so that said metal ball is left under the condition that it is bonded onto said bump, whereby at least two or more stages of the bumps made of the metal balls are formed on the electrode of the semiconductor element. According to this, after the inner lead has been positioned to face the electrode of the semiconductor element, the tip end of the inner lead is pressed by the heated bonding tool. The plated layer formed on the surface of the inner lead is melted. The bumps and the inner lead are bonded to each other through the alloy layer. In this case, the gap between the inner lead and the semiconductor element is increased in comparison with the case where the single bump made of metal ball is formed on each electrode or the bumps formed on the electrode of the semiconductor element through the electroplating process. Accordingly, it is possible to increase the amount of the alloy layer to be used for bonding. An excessive amount of the alloy layer may be prevented from coming into contact with the edge of the semiconductor element. It is therefore possible to bond together the electrode of the semiconductor element and the inner lead of the tape carrier with high reliability.

According to the invention recited in claim 3, the bump is composed of such a two-stage projection type bump made of said metal balls and formed on the electrode of the semiconductor element that the tip end of the metal wire caused to pass through a capillary is melted to form the metal ball at the tip end of said metal wire, said capillary is moved to position said metal ball on the electrode of the semiconductor element, said metal ball is bonded onto the electrode of the semiconductor element, said capillary is raised and displaced laterally to move downwardly, said metal wire is bonded onto the metal ball bonded onto the electrode of the semiconductor element, said capillary is raised again, and said metal wire is drawn and cut so that said metal ball is left under the condition that it is bonded onto the electrode of the semiconductor element. According to this, since the height of the plurality of bumps formed on the electrode of the semiconductor element is kept constant, after the inner lead has been positioned to face the electrode of the semiconductor element, when the tip end of the inner lead is pressed by the heated bonding tool, the plated layer formed on the surface of the inner lead is melted, and the bumps and the inner lead are connected through the alloy layer to each other, the inner lead is brought into contact with the bumps in a uniform manner. Accordingly, the bumps made of the respective metal balls and the inner lead are connected to each other through the alloy layer without fail. Furthermore, the contact area between the bumps and the alloy layer is increased, and the force for holding the molten alloy layer is increased. The plurality of bumps serve as resistance to prevent the flow of the molten alloy layer. Accordingly, it is possible to prevent the alloy layer from flowing toward the edge portion of the semiconductor element to prevent the contact thereto. It is therefore possible to bond together the electrode of the semiconductor element and the inner lead of the tape carrier with high reliability.

According to the invention recited in claim 4, the bump is composed of such a two-stage projection type bumps made of said metal balls (15) and formed on the electrode (2) of the semiconductor element (1) that the tip end of the metal wire caused to pass through a capillary is melted to form the metal ball at the tip end of said metal wire, said capillary is moved to position said metal ball on the electrode of the semiconductor element, said metal ball is bonded onto the electrode of the semiconductor element, said capillary is raised and displaced laterally to move downwardly, said metal wire is bonded onto the metal ball bonded to the electrode of the semiconductor element, said capillary is raised again, said metal wire is drawn and cut so that said metal ball is left under the condition that it is bonded onto the electrode of the semiconductor element, and still another two-stage projection type bump is overlapped thereon whereby the two-stage projection type bump made up of at least two stages or more of the metal balls is formed on the electrode of the semiconductor element. According to this, since the height of the plurality of bumps overlapped in at least two stages or more is kept constant, after the inner lead has been positioned to face the electrode of the semiconductor element, when the tip end of the inner lead is pressed by the heated bonding tool, the plated layer formed on the surface of the inner lead is melted, and the bumps and the inner lead are connected through the alloy layer to each other, the inner lead is brought into contact with the bumps on the respective electrodes on the semiconductor element in a uniform and secure manner. Accordingly, the respective bumps and the respective inner leads are connected to each other through the alloy layer without fail. Furthermore, since the gap between the inner lead and the semiconductor element is increased, it is possible to increase the amount of the alloy layer to be used for bonding. An excessive amount of the alloy layer may be prevented from coming into contact with the edge of the semiconductor element. It is therefore possible to bond together the electrode of the semiconductor element and the inner lead of the tape carrier with high reliability.

### BRIEF DESCRIPTION OF THE DRAWINGS

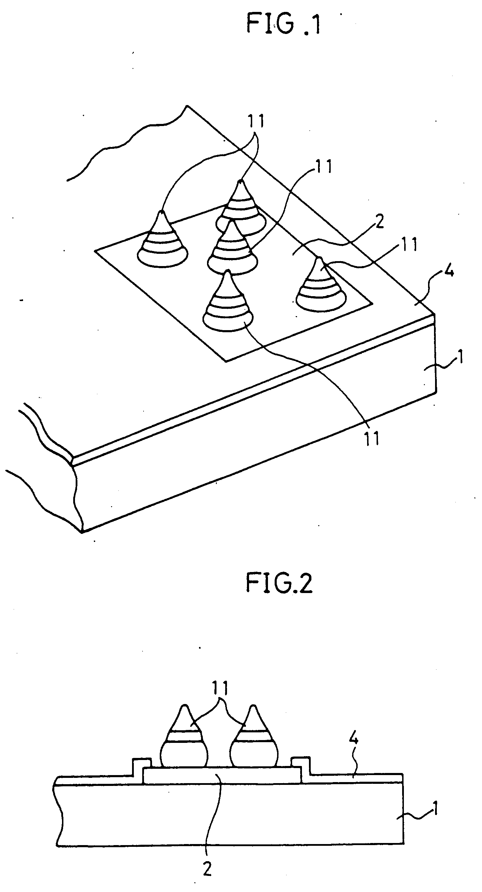

Fig. 1 is a perspective view showing bumps formed on an electrode of a semiconductor element of an electronic component device in accordance with a first embodiment of the present invention;
Fig. 2 is a frontal view showing the bumps formed on the electrode of the semiconductor element of the electronic component device in accordance with the first embodiment of the present invention;

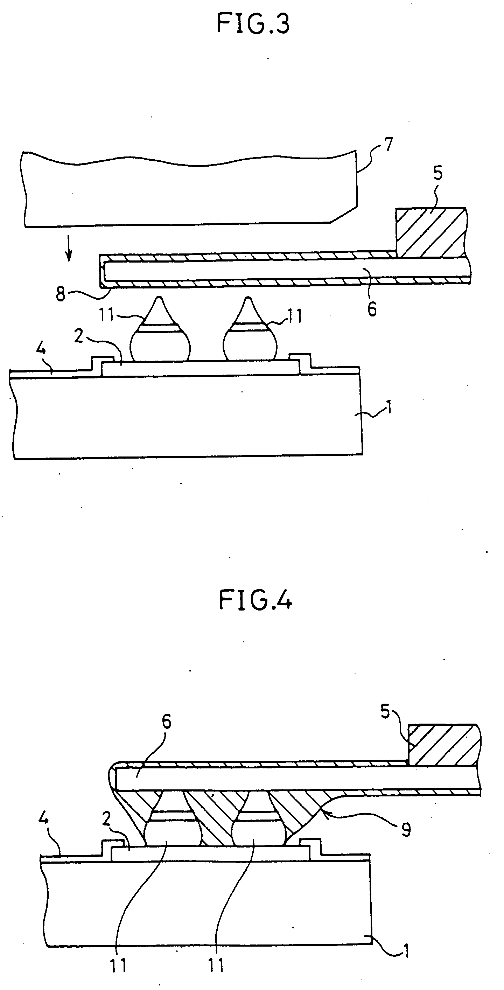

Fig. 3 is a view showing a state where the bumps formed on the electrode of the semiconductor element of the electronic component device and an inner lead of the tape carrier are to be connected to each other in accordance with the first embodiment of the present invention;
Fig. 4 is a view showing a state where the bumps formed on the electrode of the semiconductor element of the electronic component device and the inner lead of the tape carrier have been connected to each other in accordance with the first embodiment of the present invention;

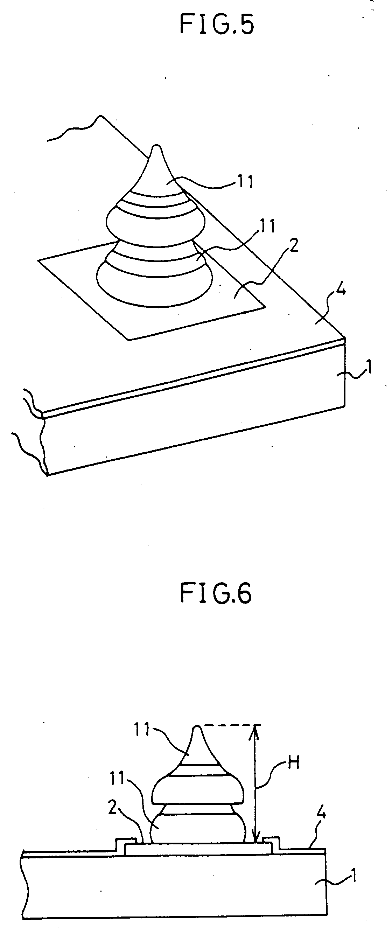

Fig. 5 is a perspective view showing bumps formed in two stages on the electrode of the semiconductor element of the electronic component device in accordance with a second embodiment of the present invention;

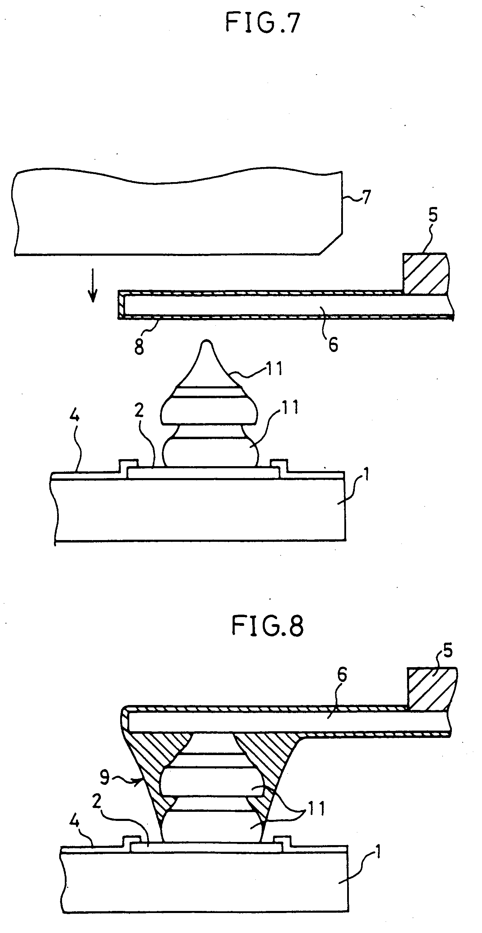

Fig. 6 is a frontal view showing the bumps formed on the electrode of the semiconductor element of the electronic component device in accordance with the second embodiment of the present invention;
Fig. 7 is a view showing a state where the bumps formed on the electrode of the semiconductor element of the electronic component device and the inner lead of the tape carrier are to be connected to each other in accordance with the second embodiment of the present invention;
Fig. 8 is a view showing a state where the bumps formed on the electrode of the semiconductor element of the electronic component device and the inner lead of the tape carrier have been connected to each other in accordance with the second embodiment of the present invention;

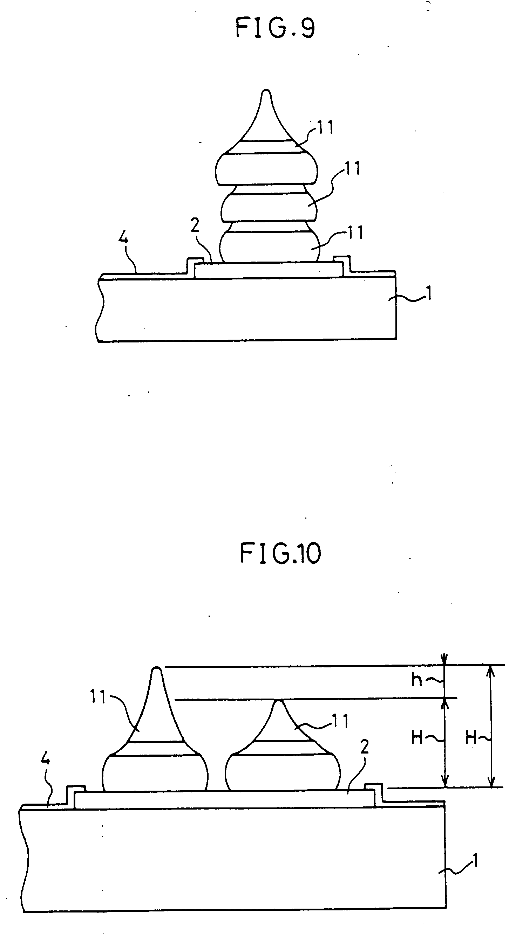

Fig. 9 is a frontal view showing bumps formed in three stages on the electrode of the semiconductor element of the electronic component device in accordance with the second embodiment of the present invention;
Fig. 10 is a view showing an unevenness of the heights of a plurality of the bumps which have been drawn and cut, formed on the electrode of the semiconductor element;

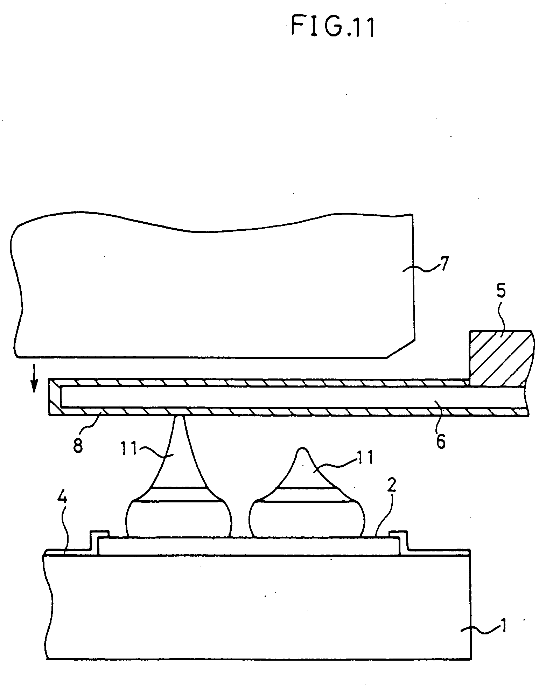

Fig. 11 is a view showing a state where the plurality of bumps which have been drawn and cut, formed on the electrode of the semiconductor element, and the inner lead of the tape carrier are to be connected to each other;

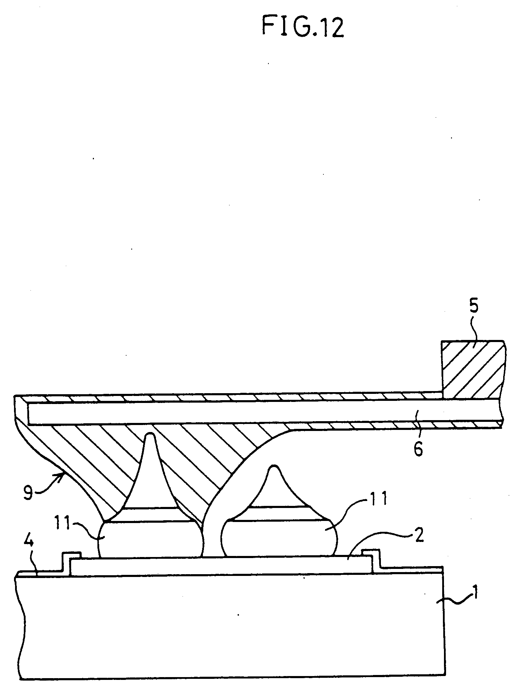

Fig. 12 is a view showing a state where the plurality of bumps which have been drawn and cut, formed on the electrode of the semiconductor element, and the inner lead of the tape carrier have been connected to each other;

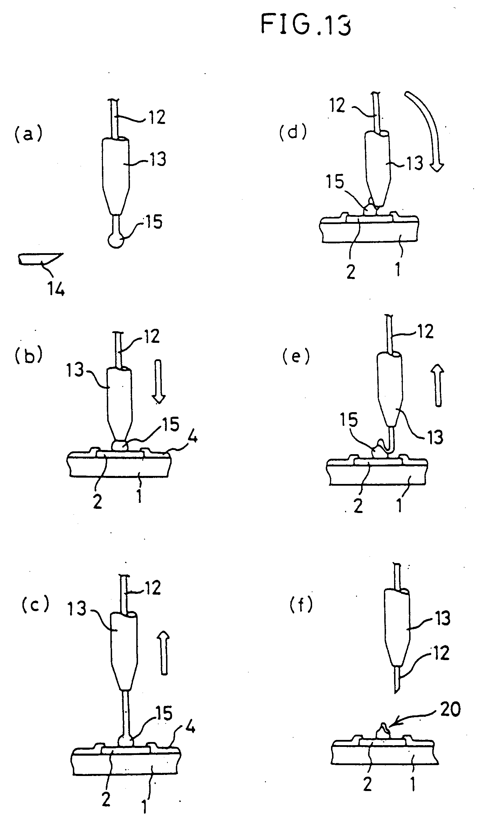

Fig. 13 is a view showing a forming process of a two-stage projection type bumps to be formed on the electrode of the semiconductor element of the electronic component device in accordance with a third embodiment of the present invention;

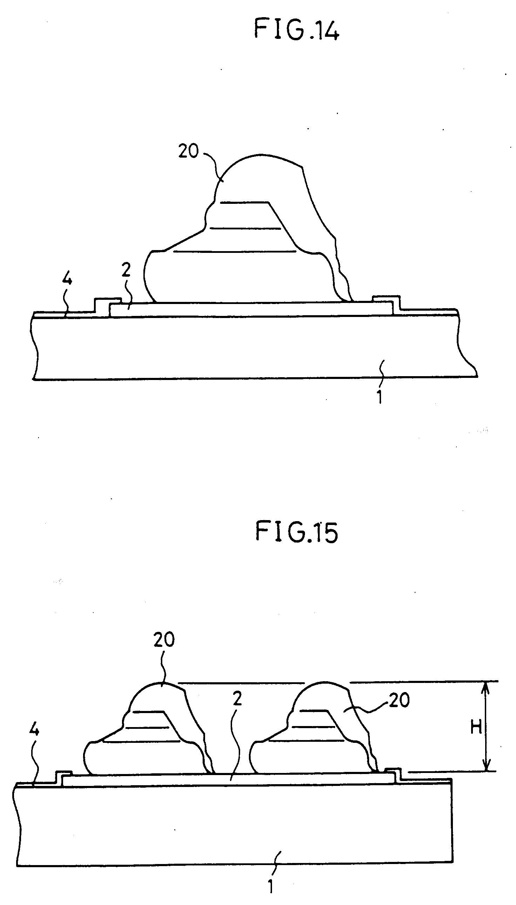

Fig. 14 is a frontal view showing the two-stage projection type bumps formed on the electrode of the semiconductor element of the electronic component device in accordance with the third embodiment of the present invention;
Fig. 15 is a frontal view showing the plurality of two-stage projection type bumps formed on the electrode in accordance with the third embodiment of the present invention;

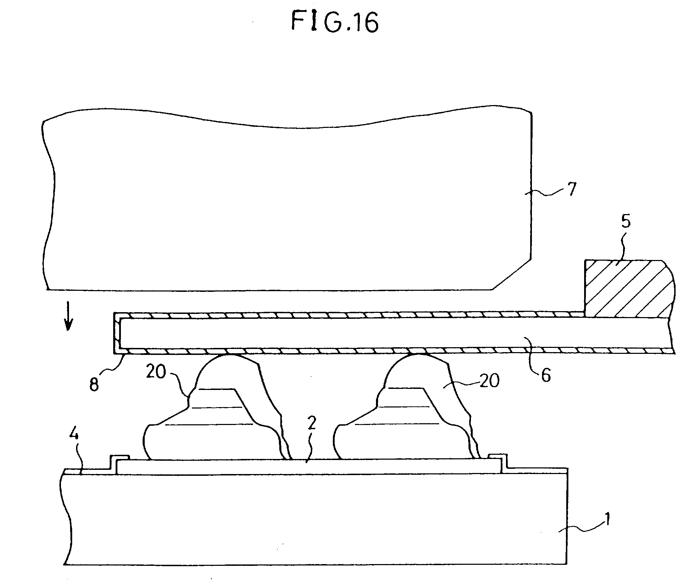

Fig. 16 is a view showing a state where the two-stage projection type bumps formed on the electrode of the semiconductor element of the electronic component device and the inner lead of the tape carrier are to be connected to each other in accordance with the third embodiment of the present invention;

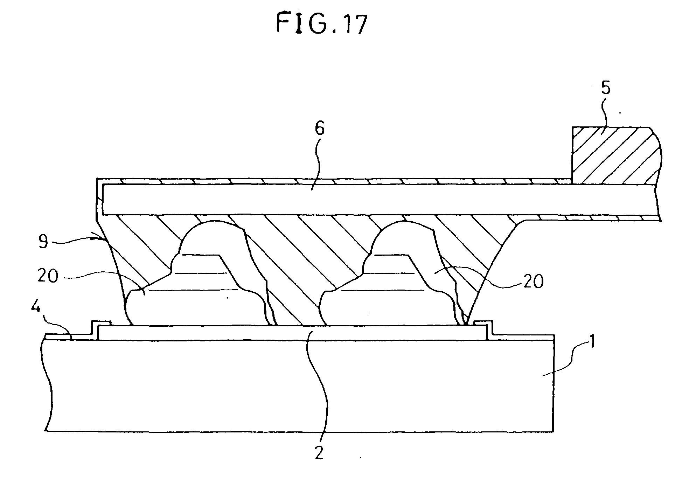

Fig. 17 is a view showing a state where the two-stage projection type bumps formed on the electrode of the semiconductor element of the electronic component device and the inner lead of the tape carrier have been connected to each other in accordance with the third embodiment of the present invention;

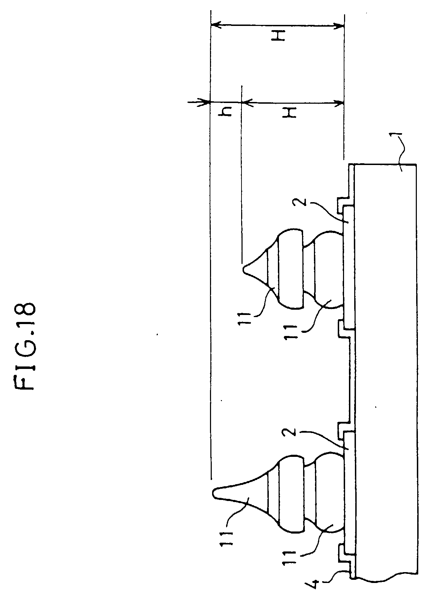

Fig. 18 is a view showing an unevenness of the heights of the bumps which have been drawn and cut, formed in two stages on the electrodes of the semiconductor element;

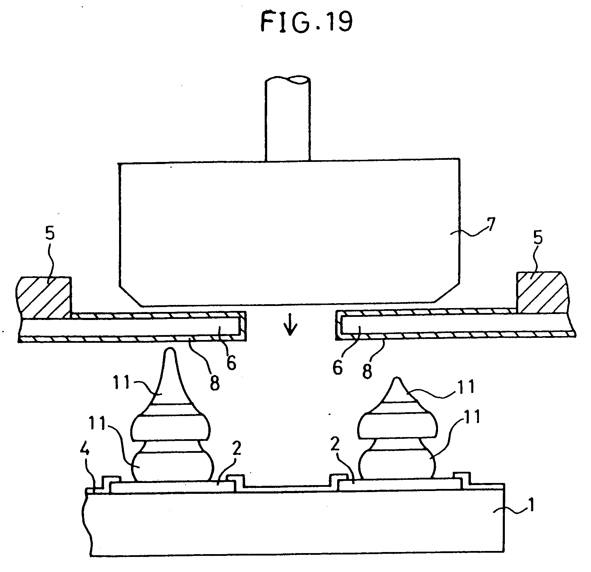

Fig. 19 is a view showing a state where the two-stage projection type bumps which have been drawn and cut, formed on the electrodes of the semiconductor element, and the inner leads of the tape carriers are to be connected to each other;

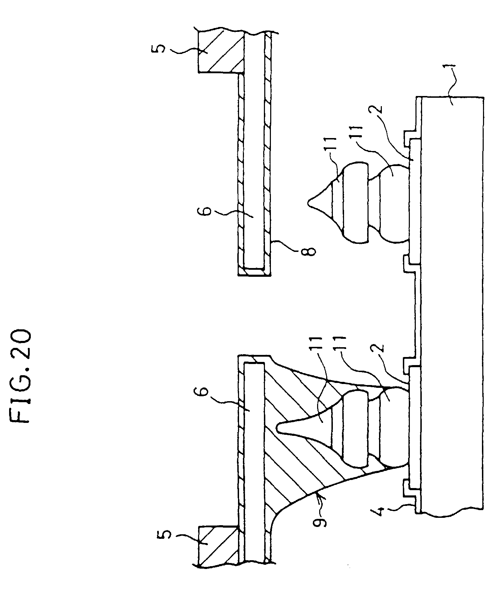

Fig. 20 is a view showing a state where the two-stage projection type bumps which have been drawn and cut, formed on the electrodes of the semiconductor element, and the inner leads of the tape carriers have been connected to each other;

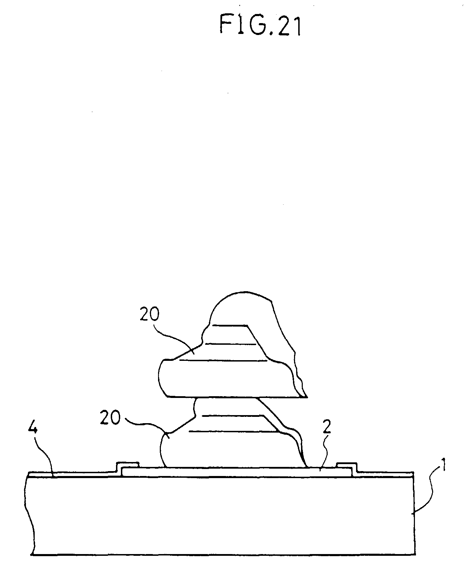

Fig. 21 is a frontal view showing the two-stage projection type bumps formed in two stages on the electrode of the semiconductor element of the electronic component device in accordance with a fourth embodiment of the present invention;

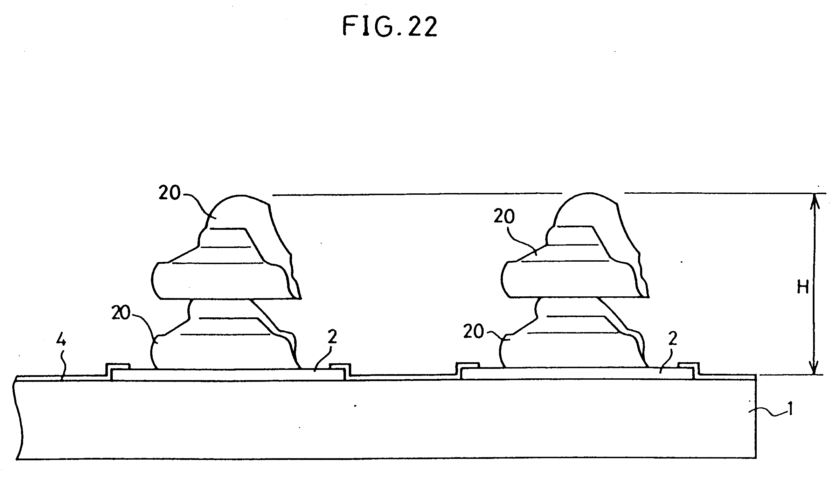

Fig. 22 is a frontal view showing the two-stage projection type bumps formed in two stages on the electrodes of the semiconductor element of the electronic component device in accordance with the fourth embodiment of the present invention;

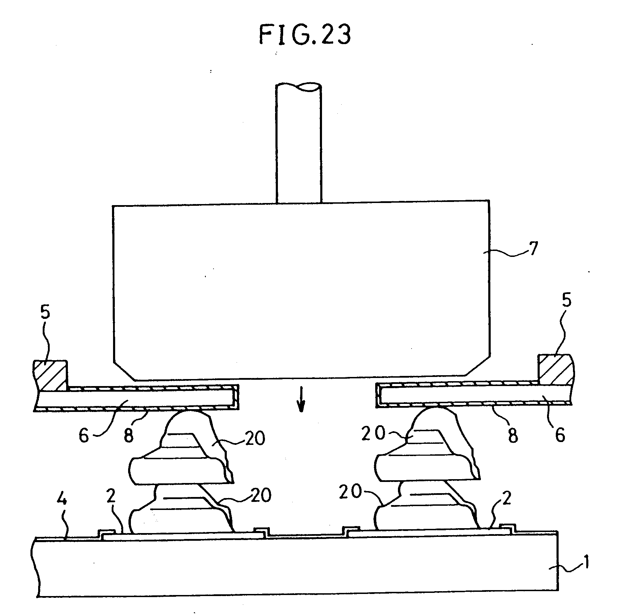

Fig. 23 is a view showing a state where the two-stage projection type bumps formed in two stages on the electrodes of the semiconductor element of the electronic component device and the inner leads of the tape carriers are to be connected to each other in accordance with the fourth embodiment of the present invention;

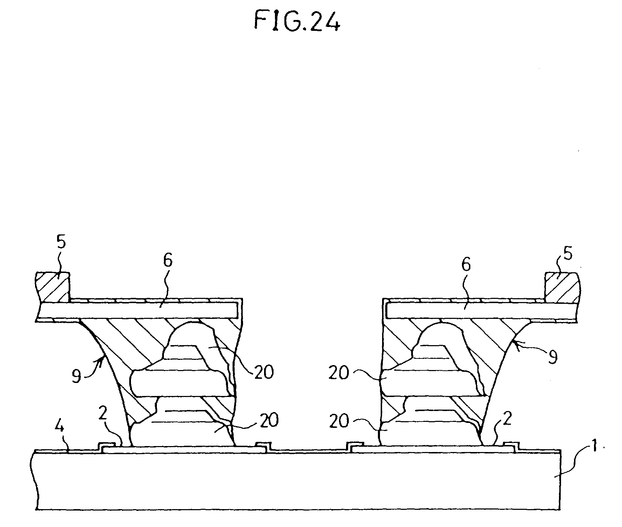

Fig. 24 is a view showing a state where the two-stage projection type bumps formed in two stages on the electrodes of the semiconductor element of the electronic component device and the inner leads of the tape carriers have been connected to each other in accordance with the fourth embodiment of the present invention;
Fig. 25 is a frontal view showing bumps formed on electrodes of a semiconductor element through an electroplating process in accordance with a prior art;
Fig. 26 is a perspective view showing the bump formed through the electroplating process in accordance with the prior art;

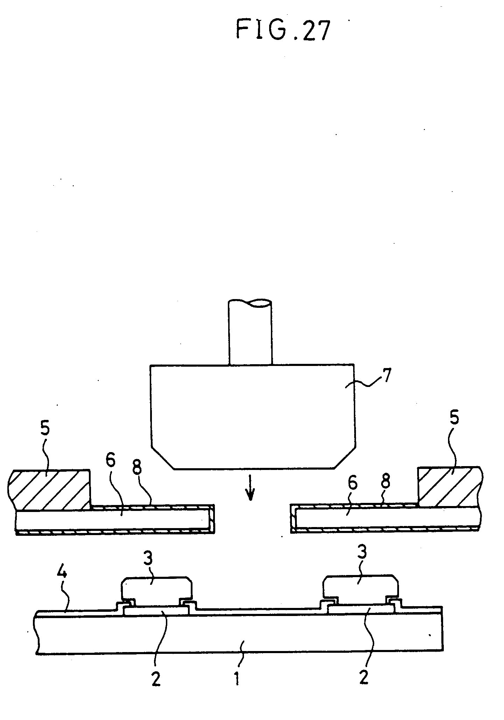

Fig. 27 is a view showing a state where the bumps formed through the electroplating process and the inner leads of the tape carriers are to be connected to each other in accordance with the prior art;
Fig. 28 is a view showing a state where the bumps formed through the electroplating process and the inner leads of the tape carriers have been connected to each other in accordance with the prior art;
Fig. 29 is a view showing a problem to be raised in the case where the bumps formed through the electroplating process and the inner leads of the tape carriers have been connected to each other in accordance with the prior art;
Fig. 30 is a view showing a production method of the bumps by using a metal ball in accordance with the prior art;
Fig. 31 is a frontal view showing the bumps made of metal balls, formed on the electrodes of the semiconductor element in accordance with the prior art;
Fig. 32 is a perspective view showing the bump made of the metal ball, formed on the electrode of the semiconductor element in accordance with the prior art;
Fig. 33 is a view showing a state where the bumps formed on the electrodes of the semiconductor element of the electronic component device and the inner leads of the tape carriers have been connected to each other in accordance with the prior art; and
Fig. 34 is a view showing a problem to be raised in the case where the bumps made of the metal balls and the inner leads of the tape carriers have been connected to each other in accordance with the prior art.

### BEST MODE FOR CARRYING OUT THE INVENTION

Embodiments of the invention will now be described with reference to Figs. 1 through 24.

### (Embodiment 1)

As shown in Figs. 1 and 2, on an active surface of a semiconductor element 1, an electrode 2 and a passivation film 4 for protecting the active surface are formed. A plurality of bumps 11 made of metal balls through a wire bonding method are formed on the electrode 2 of the semiconductor element 1. Since the wire bonding method has been described in conjunction with the prior art with reference to parts (a) to (d) of Fig. 30, the duplicated explanation will be omitted herein. After the plurality of bumps 11 have been formed on the respective electrodes 2 through the wire bonding method, as shown in Fig. 3, an inner lead 6 of a tape carrier 5 is positioned above the plurality of bumps 11 to face thereto. A tip end portion of the inner lead 6 is pressed together by a bonding tool 7 which has been heated so that a plated layer 8 made of Sn, solder or the like, formed on the surface of the inner lead 6, is melted. As a result, as shown in Fig. 4, an electronic component device in which the plurality of bumps 11 and the inner lead 6 have been connected to each other through an alloy layer 9, is formed.

According to this, since the plurality of bumps 11 made of metal balls are formed on the electrode 2 of the semiconductor element 1, the contact area between the bump 11 and the alloy layer 9 is increased in comparison with the case where the single bump 11 made of metal ball is formed on each electrode 2 as shown in Fig. 34. As a result, it is possible to increase the force to hold the molten alloy layer 9. Also, since the plurality of bumps 11 serve as a resistance to prevent the molten alloy layer 9 from flowing, thereby being capable of preventing the alloy layer 9 from flowing to the edge portion of the semiconductor element 1 and contact thereto. It is therefore possible to bond together the electrodes 2 of the semiconductor element 1 and the inner leads 6 of the tape carriers 5 with high reliability.

### (Embodiment 2)

After the bumps 11 made of metal balls have been formed on the electrode 2 of the semiconductor element 1 through the wire bonding method, as shown in Figs. 5 and 6, another bump 11 is further formed on the bump 11 through the wire bonding method, resulting in that the bumps 11 are overlapped in two stages. Namely, the metal ball 15 formed at the end of the metal wire 12 is positioned further on the first stage bump 11 made of the metal ball and formed on the electrode 2. The metal ball 15 is bonded onto the first stage bump 11 by a thermal compression bonding or a thermal compression bonding using a supersonic wave. The metal wire 12 is drawn and cut so that the metal ball 15 is left under the condition that it is bonded onto the first stage bump 11. Thus, the second stage bump 11 is formed on the first stage bump 11.

Thereafter, as shown in Fig. 7, the inner lead 6 of the tape carrier 5 is positioned above the above-described bumps 11 in two stages, to face thereto. The tip end portion of the inner lead 6 is pressed together by the bonding tool 7 which has been heated. A plated layer 8 made of Sn, solder or the like, formed on the surface of the inner lead 6, is melted. As a result, as shown in Fig. 8, an electronic component device in which the bumps 11 in two stages and the inner lead 6 are connected to each other through the alloy layer 9, is formed.

According to this, in the case where the bumps 3 are formed by the electroplating method as shown in Fig. 25, the height H is about 20 µm at maximum. Also, in the case where the single bump 11 is formed by the wire bonding method as shown in Fig. 31, the height H is about 50 µm. In contrast, in the case where the bumps 11 are overlapped in two stages by the wire bonding method as shown in Fig. 6, the height H is about 100 µm or more. Accordingly, the gap between the inner lead 6 and the semiconductor element 1 is increased as shown in Fig. 8. It is possible to increase the amount of the alloy layer 9 used for bonding. It is therefore possible to prevent the excessive amount of the alloy layer from coming into contact with the edge of the semiconductor element 1. It is possible to bond the electrode 2 of the semiconductor element 1 and the inner lead 6 of the tape carrier 5 with high reliability.

Incidentally, the bumps 11 to be overlapped are not limited to be in two stages but may be overlapped in three stages as shown in Fig. 9, or more.

### (Embodiment 3)

In the above-described embodiment (embodiment 1), when the plurality of bumps 11 (which is generally called "drawn and cut bumps") are formed on the electrode 2 by the wire bonding method, according to the adjustment of drawing and cutting of the metal wire 12 from the metal ball 15 as shown in parts (c) and (d) of Fig. 30, there is a fear that an unevenness h in height H of the respective bumps 11 would take place as shown in Fig. 10. For instance, when the plurality of bumps 11 having the height H of 45 µm are formed, the unevenness h is about ±10 µm.

Accordingly, when, as shown in Fig. 11, the inner lead 6 is positioned above the plurality of bumps 11 to face thereto, the tip end portion of the inner lead 6 is pressed together by the bonding tool 7 which has been heated, and the plated layer 8 made of Sn, solder or the like formed on the surface of the inner lead 6 is melted, some bumps 11 which are out of contact with the inner lead 6 due to the unevenness h in height H, would be generated. As a result, as shown in Fig. 12, after bonding, there is a possibility that some bumps 11 which are out of contact with the inner lead 6 through the alloy layer 9 would be generated.

In view of the above, in an embodiment (embodiment 3), in order to make uniform a height of each bump when a plurality of bumps are provided, each bump is formed into a two-stage projection shape. Namely, as shown in part (a) of Fig. 13, a metal wire 12 made of gold, copper, aluminum, solder or the like is caused to pass through a capillary 13 made of ceramic or ruby, and a discharge is effected between the tip end of the metal wire 12 which has been caused to pass therethrough and the electrode 14 which is called a torch, thereby forming the metal ball 15.

Subsequently, as shown in part (b), the above-described metal ball 15 is pressed onto the electrode 2 of the semiconductor element 1 which has been preheated. A supersonic vibration is applied thereto so that the above-described metal ball 15 is bonded onto the electrode 2 of the semiconductor element 1 by the effect of temperature, pressure, and supersonic vibration. Thereafter, as shown in part (c), the capillary 13 is raised in the vertical direction. Furthermore, as shown in part (d), the capillary 13 is displaced laterally and moved downwardly. As shown in part (e), the metal wire 12 is brought into contact with the metal ball 15. The metal wire 12 is bonded onto the metal ball 15 by the effect of the temperature and the pressure (or the temperature, the pressure, and the supersonic vibration). As shown in part (f), the capillary 13 is again raised to draw and cut the metal wire 12 to form a two-stage projection type bump 20. The height H of the thus formed two-stage projection type bumps 20 is kept constant. Accordingly, as shown in Fig. 15, when the plurality of two-stage projection type bumps 20 are formed on the electrode 2 of the semiconductor element 1, the heights H of the respective bumps 20 are kept constant. For instance, in the case where the plurality of two-stage projection type bumps 20 having a height H of 45 µm are formed, the unevenness h of the respective heights H fall within a range of ±2 µm without any problem.

Accordingly, as shown in Fig. 16, when the inner lead 6 is pressed by the bonding tool 7, the respective bumps 20 are brought into contact with the inner lead 6 without fail. As a result, as shown in Fig. 17, the respective bumps 20 and the inner lead 6 are uniformly bonded together through the alloy 9 without fail. Furthermore, in the same manner as in the above-described embodiment (embodiment 1), since the plurality of bumps 20 are formed, it is possible to prevent the alloy layer 9 from flowing to the edge portion of the semiconductor element 1. Thus, it is possible to bond the electrode 2 of the semiconductor element 1 and the inner lead 6 of the tape carrier 5 with high reliability.

### (Embodiment 4)

Even if the bumps 11 (which are generally called "drawn and cut bumps") which are overlapped in two stages by the wire bonding method as shown in the embodiment (embodiment 2), are provided on the respective electrodes 2, as shown in Fig. 18, there is a fear that the unevenness h would occur in height H of the respective bumps 11.

Accordingly, as shown in Fig. 19, in the case where the respective inner leads 6 are positioned above the bumps 11 to face thereto, formed on the respective electrodes 2, the tip end portions of the respective inner leads 6 are pressed together by the bonding tool 7 which have been heated, and the plated layers 8 made of Sn, solder or the like, formed on the surfaces of the respective inner leads 6, are melted, some bumps 11 which are out of contact with the inner leads 6 due to the unevenness h in height H, would be generated. As a result, as shown in Fig. 20, after bonding, there is a possibility that some bumps 11 which are out of contact with the inner leads 6 through the alloy layer 9 would be generated.

In view of the above, in an embodiment (embodiment 4), when the bumps formed in two stages are formed on the respective electrodes 2 of the semiconductor element 1, each bump is formed into a two-stage projection shape. Namely, the production method of the two-stage projection type bump 20 is the same as that of the above-described embodiment (embodiment 3). According to this, as shown in Fig. 22, the heights H of the respective bumps 20 overlapped in two stages are kept constant. Accordingly, as shown in Fig. 23, when the respective inner leads 6 are pressed by the bonding tool 7, the bumps 20 on the respective electrodes 2 are brought into contact with the respective inner leads 6 without fail. As a result, as shown in Fig. 24, the respective bumps 20 and the respective inner leads 6 are uniformly bonded to each other through the alloy layers 9 without fail. Furthermore, in the same manner as in the above-described embodiment (embodiment 2), the heights H of the bumps 20 are increased by overlapping the bumps 20, the gaps between the inner leads 6 and the semiconductor element 1 are increased, and the amounts of the alloy layers 9 used for bonding are increased. The excessive amount of the alloy layer may be prevented from coming into contact with the edge of the semiconductor element 1. Accordingly, it is possible to bond the electrodes 2 of the semiconductor element 1 and the inner leads 6 of the tape carriers 5 together with high reliability.

Incidentally, the number of the bumps 20 to be overlapped one on another is not limited to two but may be three or more.

## Claims

1. An electronic component device in which, when a semiconductor element (1) is bonded onto an inner lead (6) of a tape carrier (5), a metal ball (15) formed by melting a tip end of a metal wire (12) is bonded onto an electrode (2) of said semiconductor element (1) so as to form a bump (11) on the electrode (2) of said semiconductor element (1), a plated layer (8) is formed on the surface of said inner lead (6), and under the condition that said inner lead (6) is positioned in alignment with the bump (11) of the semiconductor element (1), said plated layer (8) is melted in order that the semiconductor element (1) is bonded to said inner lead (6) through an alloy layer (9), characterized in that a plurality of bumps (11) made of said metal balls (15) are formed on said electrode (2) of the semiconductor element (1).

2. An electronic component device in which, when a semiconductor element (1) is bonded to an inner lead (6) of a tape carrier (5), a metal ball (15) formed by melting a tip end of a metal wire (12) is bonded on an electrode (2) of said semiconductor element (1) so as to form a bump (11) on the electrode (2) of said semiconductor element (1), a plated layer (8) is formed on a surface of said inner lead (6), and under the condition that said inner lead (6) is positioned in alignment with the bump (11) of the semiconductor element (1), said plated layer (8) is melted in order that the semiconductor element (1) is bonded to said inner lead (6) through an alloy layer (9), characterized in that a metal ball (15) formed at a tip end of the metal wire (12) is further bonded onto the bump (11) made of said metal ball (15) and formed on the electrode (2) of said semiconductor element (1), and said metal wire (12) is drawn and cut so that said metal ball (15) is left under the condition that it is bonded onto said bump (11), whereby at least two or more stages of the bumps (11) made of the metal balls (15) are formed on the electrode (2) of the semiconductor element (1).

3. The electronic component device according to claim 1, further characterized in that the bump (11) is composed of such a two-stage projection type bump (20) made of said metal balls (15) and formed on the electrode (2) of the semiconductor element(1) that the tip end of the metal wire (12) caused to pass through a capillary (13) is melted to form the metal ball (15) at the tip end of said metal wire (12), said capillary (13) is moved to position said metal ball (15) on the electrode (2) of the semiconductor element (1), said metal ball (15) is bonded onto the electrode (2) of the semiconductor element (1), said capillary (13) is raised and displaced laterally to move downwardly, said metal wire (12) is bonded onto the metal ball (15) bonded onto the electrode (2) of the semiconductor element (1), said capillary (13) is raised again, and said metal wire (12) is drawn and cut so that said metal ball (15) is left under the condition that it is bonded onto the electrode (2) of the semiconductor element(1).

4. The electronic component device according to claim 2, further characterized in that the bump (11) is composed of such a two-stage projection type bump (20) that the tip end of the metal wire (12) caused to pass through a capillary (13) is melted to form the metal ball (15) at the tip end of said metal wire (12), said capillary (13) is moved to position said metal ball (15) on the electrode (2) of the semiconductor element (1), said metal ball (15) is bonded to the electrode (2) of the semiconductor element (1), said capillary (13) is raised and displaced laterally to move downwardly, said metal wire (12) is bonded onto the metal ball (15) bonded to the electrode (2) of the semiconductor element (1), said capillary (13) is raised again, said metal wire (12) is drawn and cut so that said metal ball (15) is left under the condition that it is bonded onto the electrode (2) of the semiconductor element (1), and still another two-stage projection type bump (20) is overlapped thereon whereby the two-stage projection type bump (20) made of two stages or more of the metal balls (15) is formed on the electrode (2).
